Europäisches Patentamt

European Patent Office

Office européen des brevets

(19)

(11) Publication number: **0 405 672 A1**

## EUROPEAN PATENT APPLICATION

(21) Application number: 90201648.4

(22) Date of filing: 25.06.90

(51) Int. Cl.⁵: **G01R 31/28**

(30) Priority: 30.06.89 NL 8901664

(43) Date of publication of application:
02.01.91 Bulletin 91/01

(84) Designated Contracting States:
**DE FR GB**

(71) Applicant: **N.V. Philips' Gloeilampenfabrieken**
**Groenewoudseweg 1**
**NL-5621 BA Eindhoven(NL)**

(72) Inventor: **Horstman, Robert Edward**
**c/o INT. OCTROOIBUREAU B.V. Prof.**
**Holstlaan 6**
**NL-5656 AA Eindhoven(NL)**

(74) Representative: **Zwaan, Andries Willem et al**
**INTERNATIONAAL OCTROOIBUREAU B.V.**
**Prof. Holstlaan 6**
**NL-5656 AA Eindhoven(NL)**

(54) **Method of measuring a voltage distribution across a conductor pattern.**

(57) The voltage distribution across a conductor pattern of a printed circuit board can be measured by means of an electron beam device, thus enabling the testing of components mounted on the printed circuit board.

## METHOD OF MEASURING A VOLTAGE DISTRIBUTION ACROSS A CONDUCTOR PATTERN.

The invention relates to a method of measuring a voltage distribution across a conductor pattern of a printed circuit board, the printed circuit board being scanned by means of an electron beam generated by an electron beam device, electrons emitted by the printed circuit board being detected by means of an electron detector.

The invention also relates to a device for measuring a voltage distribution across a conductor pattern of a printed circuit board.

From "Journal of Electronic Engineering", October 1988, pp. 56-62 it is known that electrical components of numerous electrical apparatus are interconnected by means of a conductor pattern provided on a printed circuit board. The mounting of a large number of components on a comparatively small surface area requires a high density of the conductor pattern, conductor tracks of which are usually spaced less than 1 mm apart. During the soldering of the components on the printed circuit board, usually performed automatically, the conductor pattern is liable to be locally short-circuited or components are liable to be mounted in an incorrect position or in an incorrect location on the printed circuit board. In order to test the quality of a printed circuit board provided with components, a crobe comprising a large number of pins is customarily arranged on the conductor pattern of the printed circuit board. Using these pins, numbering from 800 to 8000, the voltage distribution across the conductor pattern is measured. The signals which may have a frequency of some MHz and which are measured by the probe on the conductor pattern are analysed by means of, for example a computer in order to detect faults in the conductor pattern or the components. A method of this kind has the drawback that different probes are required for the testing of printed circuit boards comprising different conductor patterns. The complexity of the probes makes their construction expensive and time consuming. The probes, usually having an acrylic ebonite or glass ebonite base in which the pins are secured, collect a static charge so that a voltage on the pins may become as high as from 1000 to 2000 V. In order to prevent damaging of the printed circuit board, special facilities are required for dissipating the charge. It is a further drawback of the known method that mechanical contact is required between the pins and the printed circuit board which is thus liable to be damaged.

It is inter alia an object of the invention to provide an efficient and flexible method of measuring a voltage distribution across a conductor pattern of a printed circuit board in which the described drawbacks are eliminated.

To achieve this, a method in accordance with the invention is characterized in that first an image of the conductor pattern is determined by scanning a part of the printed circuit board, after which exclusively the conductor pattern is scanned.

An electron beam can be applied to any point on the conductor pattern. A surface struck by the incident electron beam emits secondary electrons. When the number of secondary electrons equals the number of electrons incident on the surface, no charge is accumulated on the printed circuit board. Depending on the potential of the landing surface, the number of electrons emitted varies. Only electrons of sufficiently high energy can escape from a landing surface carrying a comparatively high potential. Because landing surfaces carrying a negative potential emit a comparatively large number of secondary electrons in comparison with landing surfaces carrying a more positive potential, a voltage-dependent contrast arises between the landing surfaces. According to another method of making visible voltage differences on the landing surface, the secondary electrons are accelerated from the landing surface by a positive electrode. By decelerating the electrons in an electric field before they reach the detector, the number of electrons reaching the detector will vary in dependence on the potential of the landing surface. The detector signal is maintained at a constant value by adjustment of the potential of the decelerating electrode. The potential of the decelerating electrode is then a measure of the potential of the landing surface. Despite a comparatively slow detector response, for example stroboscopic irradiation of the landing surface, in which case the electron beam is periodically incident on the landing surface, enables measurement of signals on the conductor pattern which have a frequency of a few GHz. The electron energy of the primary electron beam for which the primary and the secondary electron current to and from the landing surface are equal is dependent on the material of the landing surface. If the energy of the electron beam is such that no charge accumulation occurs on the conductor pattern when a printed circuit board is scanned by the electron beam, charge accumulation will occur on non-conductive parts of the printed circuit board when such parts are scanned by the same electron beam. This is prevented by scanning exclusively the conductor pattern. Because the deflection of the electron beam can be controlled, for example by way of a computer, adaptation to the conductor pattern can be comparatively simply achieved for printed circuit boards with different conductor patterns after determination of the image thereof, for example, by automatic adjustment of the deflection. Because the electron beam hardly forms an electric load for the printed circuit board, no facilities need be provided on the printed circuit board for the dissipation of undesirable high potentials. Hardly any mechanical contact with the conductor pattern occurs during the testing, so that mechanical damage is avoided.

It is to be noted that the measurement of potentials at nodes of an integrated circuit by means of an electron beam is known per se from E. Menzel, K.Kubalek: "Fundamentals of Electron Beam Testing of Integrated Circuits", Scanning, Vol. 5.3 (1983).

However, the cited article does not offer any hint whatsoever that such a method can also be used for testing a voltage distribution across a conductor pattern of a printed circuit board whose dimensions are usually some orders of magnitude greater than those of an integrated circuit.

From US 4,169,244 a method of testing printed circuit boards by means of an electron beam is known where a printed circuit board is positioned relative to the electron beam by the detection of reference points on the printed circuit board. When the printed circuit board occupies the correct position, a computer supplies a deflection device with deflection instructions for deflecting the electron beam to predetermined positions on the printed circuit board. According to this method, new deflection instructions must be programmed for different printed circuit boards. According to a method in accordance with the invention this is facilitated by determining an image of the conductor pattern to be tested, which image is suitable for automatic determination of the deflection instructions. When the image is displayed on a television monitor, a visual indication of the quality of the conductor pattern is also obtained.

A version of a method in accordance with the invention is characterized in that the printed circuit board is arranged in a vacuum space surrounding the electron beam device, so that the vacuum space is subdivided into two separate compartments, a cooling agent being guided along the printed circuit board in one of the compartments.

Consequently, the printed circuit board can be cooled in one of the compartments by means of, for example a low-pressure gas. Because of the low pressure of the cooling agent, for example 1-10 Torr for a pressure in the vacuum space of $10^{-6}$ Torr, bending of the printed circuit board and hence damaging of the conductor pattern is prevented.

A device for measuring a voltage distribution across a conductor pattern in accordance with the invention, comprising an electron gun for generating an electron beam, a holder which is arranged opposite the electron gun and whichsupports the printed circuit board, a deflection device which is arranged between the electron gun and the holder in order to deflect the electron beam, and an electron detector for detecting electrons emitted by the printed circuit board, is characterized in that a beam blanking device is arranged between the electron gun and the holder.

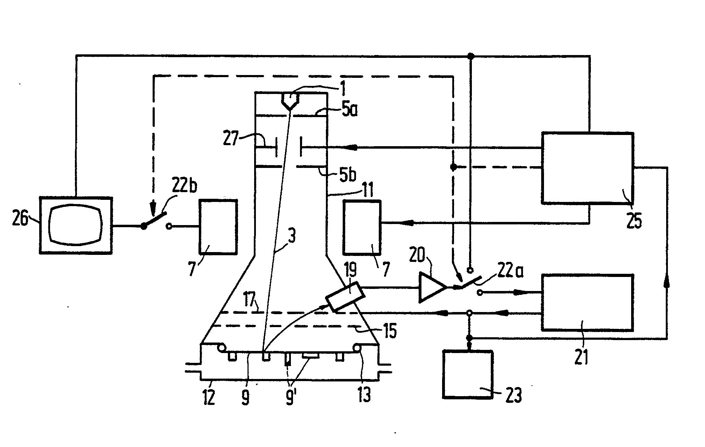

A simple embodiment of such a device comprises, for example, an electron gun and a deflection device of the kind used in a television receiver, the beam blanking device for stroboscopic irradiation of the landing surface being mounted between the electron gun and the deflection device, which beam blanking device comprises, for example two electrically chargeable plates which are mounted near an electron beam path. A device of this kind will be described in detail hereinafter with reference to the accompanying drawing.

The sole Figure of the drawing shows an electron gun 1 which comprises, for example a thermal or semiconductor cathode for generating an electron beam 3. The electron beam is accelerated between electrodes 5a and 5b. The deflection device 7, for example in the form of deflection coils, deflects the electron beam 3 before it is incident on a printed circuit board 9 whose components 9', being connected, for example to a power supply source which is not shown in the Figure, are situated on a side which is remote from the electron beam. The printed circuit board is arranged within a vacuum space 11 of the device and divides the vacuum space 11 into two separate compartments. The compartments are separated from one another in a vacuum-tight manner by means of, for example a sealing ring 13. Via connection apertures 14, a cooling system can be connected to the compartment 12 for the cooling of the printed circuit board by means of, for example a low-pressure gas. In addition to the suitable thermal conductivity, cooling by means of a rarified gas offers the advantage that the vacuum in the vacuum space will not be excessively disturbed in the case of small leaks in the printed circuit board. The deflection device 7 deflects the electron beam across the conductor pattern. The position of the conductor pattern is measured and stored in a computer 25 by way of a first scanning operation. In order to restrict the charging of non-conductive parts of a printed circuit board, having a thickness of, for example 1 mm, to 0.1 V, an electron beam with an electron current of 1 nA should not reside longer than 1 $\mu$s on a non-conductive surface of 1 $mm^2$. In order to counteract charging of non-conductive parts, such parts may be provided with a conductive layer. The landing surface emits secondary electrons so that substantially no charge is accumulated on the conductor pattern. Depending on the potential present on the landing surface, the secondary electrons are emitted with more energy in the case of a negative potential, or with less energy in the case of a positive potential. A collector grid 15 which is situated at a distance $d_r$ above the landing surface accelerates the secondary electrons from the surface of the printed circuit board, after which the electrons are decelerated in an electric field between the collector grid 15 and a deceleration electrode 17. The collector grid 15 has a potential $V_r$ for which: $V_r/d_r$ $V \gg_s d/d_s$. Therein, $V_s$ is the potential of the landing surface and $d_s$ is a distance between two neighbouring conductor tracks of the conductor pattern. Only electrons having an energy which is high enough to overcome the decelerating electric field will reach the electron detector 19. The electron detector 19 comprises, for example a phosphor entrance screen whereby incident electrons are absorbed while emitting light. This light is converted into an electric signal by means of a photomultiplier tube. This signal is intensified and possibly integrated by an intensifier/integrator 20 and depends on the potential of the landing surface. The measured number of secondary electrons varies as a function of the voltage of the deceleration electrode 17 with respect to the potential of the printed circuit board. However, this variation is not linear. However, when the signal originating from the intensifier/integrator 20 is fed back to the deceleration electrode 17 by means of a feedback unit 21 so that the potential of the electrode 17 is adjusted to a value for which the number of detected electrons has a predetermined value, the value of the potential of the electrode 17 will be a direct measure of the potential of the printed circuit board at the area of the landing surface. The voltage of the printed circuit board can be displayed by means of a display unit 23, for example a digital voltmeter, or can be stored in the computer 25. Instead of a quantitative voltage measurement, a qualitative voltage measurement can also be performed. To this end, for example by switching over a switch 22a, the signal originating from the intensifier/integrator 20 is presented to a television receiver 26 as a video signal. By switching over a switch 22b, the electron beam 3 is deflected across the printed circuit board by the deflection device 7 in synchronism with a deflection frequency of the television receiver 26 (50 or 60 Hz). The part of the printed circuit board scanned by the electron beam 3 is then displayed on the television receiver 26, the brightness of parts of the conductor pattern which carry a high potential being distinct from that of parts of the conductor pattern which carry a low potential. For display of a voltage which varies in time in the conductor pattern, the electron beam 3 is periodically directed onto the scanning surface, using a beam blanking device 27 controlled by the computer 25, for example with a predetermined phase with respect to the voltage on the landing surface which is periodic in time. A time-dependent voltage can thus be sampled on different landing surfaces.

## Claims

1. A method of measuring a voltage distribution across a conductor pattern of a printed circuit board, the printed circuit board being scanned by means of an electron beam generated by an electron beam device, electrons emitted by the printed circuit board being detected by means of an electron detector, characterized in that first an image of the conductor pattern is determined by scanning a part of the printed circuit board, after which exclusively the conductor pattern is scanned.

2. A method as claimed in Claim 1, characterized in that the printed circuit board is provided with an electrically conductive layer before being scanned.

3. A method as claimed in Claim 1 or 2, characterized in that the printed circuit board is arranged in a vacuum space surrounding the electron beam device so that the vacuum space is subdivided into two separate compartments, a cooling agent being guided along the printed circuit board in one of the compartments.

4. A method as claimed in Claim 3, characterized in that a rarified gas is used as the cooling agent.

5. A device for measuring a voltage distribution across a conductor pattern of a printed circuit board, comprising an electron gun for generating an electron beam, a holder which is arranged opposite the electron gun and which supports the printed circuit board, a deflection device which is arranged between the electron gun and the holder in order to deflect the electron beam, and an electron detector for detecting electrons emitted by the printed circuit board, characterized in that a beam blanking device is mounted between the electron gun and the holder.

6. A device as claimed in Claim 5, the device comprising a vacuum envelope which surrounds the device and which can be subdivided into two separate compartments by the printed circuit board, characterized in that the vacuum envelope comprises connection apertures for connecting a cooling system to one of the compartments.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 169 244 (PLOWS)<br>* Column 3, lines 23-35; column 3, line 63 - column 4, line 3; figure 1 * | 1,5 | G 01 R 31/28 |
| X | GB-A-2 149 130 (I.C.L.)<br>* Page 2, lines 47-105 * | 1,5 | |
| A | EP-A-0 264 482 (IBM)<br>* Column 4, lines 13-43 * | 2 | |
| A | US-A-4 507 605 (GEISEL)<br>* Column 3, lines 3-43; column 4, lines 39-54 * | 3-4 | |
| A | EP-A-0 261 829 (MARCONI INSTRUMENTS)<br>* Column 4, line 21 - column 5, line 46; figures 2-3 * | 3,6 | |
| A | EP-A-0 266 535 (IBM)<br>* Figure 1 * | | |

TECHNICAL FIELDS
SEARCHED (Int. Cl.5)

G 01 R

The present search report has been drawn up for all claims

| Place of search | Date of completion of the search | Examiner |
|---|---|---|
| THE HAGUE | 04-10-1990 | HOORNAERT W. |

EPO FORM 1503 03.82 (P0401)